# EUROPEAN PATENT APPLICATION

(11) **EP 1 119 046 A2**
(43) Date of publication of application: **25.07.2001**
(21) Application number: 01300294.4
(22) Date of filing: 15.01.2001
(51) Int. Cl.: H01L 23/485

(54) **Wire bonding technique and architecture suitable for copper metallization in semiconductor structures**

(30) Priority: 21.01.2000 US 488810
(71) Applicant: LUCENT TECHNOLOGIES INC., Murray Hill, New Jersey 07974-0636 (US)
(72) Inventor: Chittipeddi, Sailesh, Allentown, Pennsylvania 18104 (US); Mansinh Merchant, Sailesh, Orlando, Florida 32835 (US); Roy, Pradip Kumar, Orlando, Florida 32819 (US)
(74) Representative: Williams, David John

(57) **Abstract**

A structure and a method for enabling use of wire bonding and Controlled Collapse Chip Connection technologies in external connections with Cu interconnect wiring in integrated circuits.

A structure for connecting integrated circuitry has a first segment of conductor predominantly comprising Cu. The conductor segment is formed on an integrated circuit structure and includes a contact region for electrical connection. A conductive barrier layer formed about the contact region for mitigating migration of Cu atoms from the contact region to other conductor material. A conductive contact layer is formed about the barrier layer such that the barrier layer is disposed between the contact region and the contact layer. With this structure a bond wire, predominantly comprising Au, may be mechanically connected to the conductive layer for electrical connection through the barrier layer to the bonding pad. According to a preferred embodiment of the invention the conductive contact layer is an A1 bond pad and the barrier layer is a refractoryu metal or a compound of a refractory metal.

A method for forming a connection between an upper level of copper-containing interconnect in an integrated circuit structure and an external contact involves forming a conductive barrier layer in electrical contact with a portion of the first upper level and forming a conductive contact layer in electrical connection with the barrier layer. In a preferred embodiment the conductive contact layer predominantly comprises A1 and a conductive material predominantly comprising Au is positioned for electrical connection between the conductive contact layer and the external contact.

## Description

### Field of the Invention

The present invention relates to integrated circuits and, more particularly, to the bonding of copper interconnect structures on an integrated circuit die to external conductive contacts.

### Background of the Invention

As the density and complexity of multilevel interconnection schemes increase, performance requirements of interconnect architectures have become one of the most demanding aspects of ultra large scale integration efforts. It is well known that the speed of signals propagating on interconnect circuitry varies inversely with line resistance and capacitance. Thus with feature sizes and spacings becoming smaller, the speed of integrated circuitry depends less on the switching device characteristics and more on the electrical properties of the interconnect structure. While in the past Al alloys have found great acceptance in formation of integrated circuit metallization schemes, there is now a growing need to deploy materials such as Cu having lower resistivities (e.g., less than 2 micro ohm cm).

Although low resistivity materials such as copper provide the benefits of increased current density and reduced RC time delays, process integration issues and increased manufacturing costs have impeded the use of these materials for interconnect structures. For example, Cu diffuses rapidly in both silicon and conventional dielectric materials, leading to shifts in transistor threshold voltages and junction leakages. Cu lines cannot be so easily patterned as Al lines, requiring use of complex Damascene and Dual Damascene processes in order to form low resistivity interconnect structures. Cu also corrodes very easily and its oxides are not self passivating. In fact, because the oxide layer may be several nm in thickness, removal of the oxide to create a reliable metallurgical bond is difficult. In contrast aluminum oxide layers are self passivating and less than 0.2 nm thick when formed on an interconnect line. As a further complication, Cu does not integrate well with other interconnect metals, especially Al. That is, resulting interdiffusion at the Al - Cu interface leads to formation of compounds which do not allow for a stable mechanical bond between the dissimilar metals.

While solutions to some of these problems have been proposed or implemented, they have significant cost implications and require the replacement of otherwise compatible equipment in what is already a very capital intensive industry. Specifically, the properties of Cu have made it difficult to deploy conventional wire bonding techniques to provide low resistivity connections between the Cu metallization and package or substrate contacts. Thus it is a desire in the art to construct a package interconnect architecture which accommodates the difficult properties of Cu while maintaining the simplicity and economy of conventional bonding technologies.

### Summary of the Invention

The present invention provides a structure and a method for enabling use of wire bonding and Controlled Collapse Chip Connection (C4) technologies to effect external connections with Cu interconnect wiring in integrated circuits. According to the invention an integrated circuit comprises a segment of conductor on an integrated circuit die and a bond pad. The segment of conductor includes a contact region for electrical connection. A conductive barrier layer is disposed between the contact region and the bond pad for mitigating migration of conductor segment constituents from the contact region to the bond pad. According to a method for making an integrated circuit device a first segment of conductor is formed and a bond pad is formed for electrical connection with the first segment. A conductive barrier layer is interposed between the first segment and the bond pad to mitigate migration of conductor material from the first segment to the bond pad.

According to one embodiment of the invention a structure for connecting integrated circuitry has a first segment of conductor predominantly comprising Cu. The conductor segment is formed on an integrated circuit structure and includes a contact region for electrical connection. A conductive barrier layer formed about the contact region for mitigating migration of Cu atoms from the contact region to other conductor material. A conductive contact layer is formed about the barrier layer such that the barrier layer is disposed between the contact region and the contact layer. With this structure a bond wire, predominantly comprising Au, may be mechanically connected to the conductive layer for electrical connection through the barrier layer to the bonding pad. According to a preferred embodiment of the invention the conductive contact layer is an Al bond pad and the barrier layer is a refractory metal or a compound of a refractory metal.

According to one embodiment of the inventive method there is provided a process for forming a connection between copper-containing interconnect in an integrated circuit structure and an external contact. The method involves forming a conductive barrier layer in electrical contact with the interconnect and forming a conductive contact layer in electrical connection with the barrier layer. In a preferred embodiment the conductive contact layer predominantly comprises Al. A conductive material predominantly comprising Au is positioned for electrical connection between the conductive contact layer and the external contact.

### Brief Description of the Drawings

A more complete understanding of the invention will be acquired from the detailed description which follows, when read in conjunction with the accompanying figures in which all of the drawings provide partial cross sectional views of integrated circuit structures. Specifically:
Figure 1 provides a view of a partially fabricated Damascene integrated circuit structure suitable for practicing the invention;
Figures 2 through 4 provide cross sectional views of the integrated circuit structure processed according to the invention;
Figures 5 through 8 provide partial cross sectional views illustrating integration of the invention into a dual Damascene structure; and
Figures 9 through 11 illustrate, according to an alternate embodiment, integration of the invention into a dual Damascene structure.

Like numbers denote like elements throughout the figures and text. Features presented in the drawings are not to scale.

### Detailed Description of the Invention

The invention may be most useful in complex semiconductor structures having four or more levels of interconnect such as microprocessors, digital signal processors or so called systems on a chip. Such devices, when fabricated with ULSI processes, e.g., geometries of 0.2 micron and less, will have circuit densities and electrical performance requirements which demand the low resistivity achievable with Cu metallization schemes.

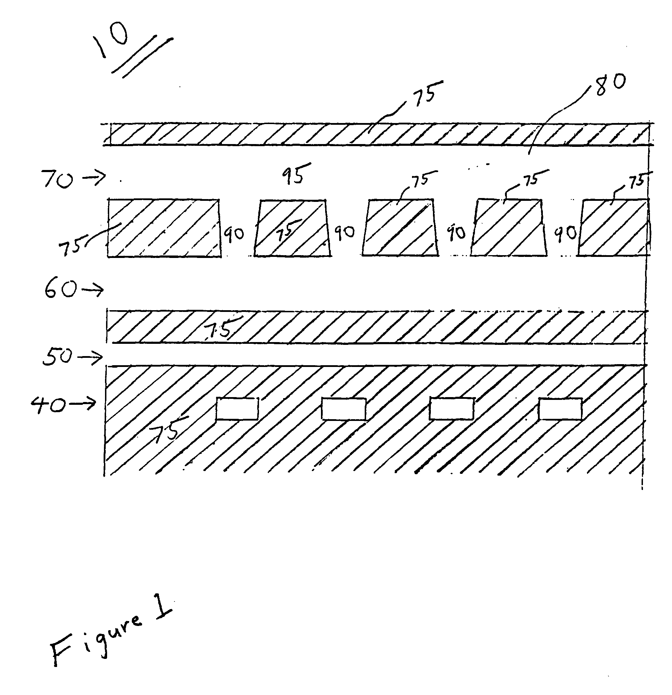

With reference to Figure 1 there is shown in a partial cross sectional view the structure 10 of a partially completed integrated circuit die undergoing final stages of fabrication. Several upper levels of Cu interconnect are formed over a semiconductor substrate (not shown) having, for example, transistor switching devices formed thereon. Some or all of the interconnect levels may be formed with a Damascene or dual Damascene Cu fabrication process. Cu lines may be formed by electroplating. Specifically, the figure illustrates interconnect levels 40, 50, 60 and 70 each formed in deposits 75 of dielectric material. The view of Figure 1 is taken along a plane parallel to the direction in which levels 50, 60 and 70 of interconnect run in order to illustrate those levels in cross section while the same plane is orthogonal to the direction along which level 40 runs. Each level of interconnect comprises a plurality of conductive members or runner portions. An individual dual Damascene Cu member 80, part of the interconnect level 70, is shown in order to describe a first preferred embodiment of the invention. This and other Damascene levels of the interconnect structure are each individually formed by generally known process steps such as follows.

A Damascene or dual Damascene intermetal dielectric layer is deposited over a previously-formed level of interconnect. This dielectric will typically be multi-layered, formed with etch stops such as silicon nitride and planarized by chemical mechanical polishing (CMP). The desired configuration of the Cu line is patterned and etched in the dielectric material to form trench-like openings therein. A conductive barrier material (not shown in Figure 1) such as Ta, TaN or TiN is deposited along the surfaces of the openings to prevent migration of Cu deposited in the openings. Barrier deposit may be had be chemical vapor deposition (CVD) or physical vapor deposition (PVD). The Cu deposit is initiated with deposition of a seed layer on the barrier material, followed by electrodeposition of Cu (e.g., from copper sulfate) to fill the openings. For dual Damascene structures such as level 70 the deposition is a two-step process wherein a via portion 90 is formed in an initial opening of one dielectric deposit and a runner portion 95 is formed about a second deposit of dielectric material. An anneal stabilizes the microstructure and avoids secondary re-crystallization effects. Excess Cu and barrier material are removed by CMP as the surface is planarized. This sequence is repeated for each level of interconnect until the final Cu layer of interconnect is passivated and the structure is prepared for packaging and assembly.

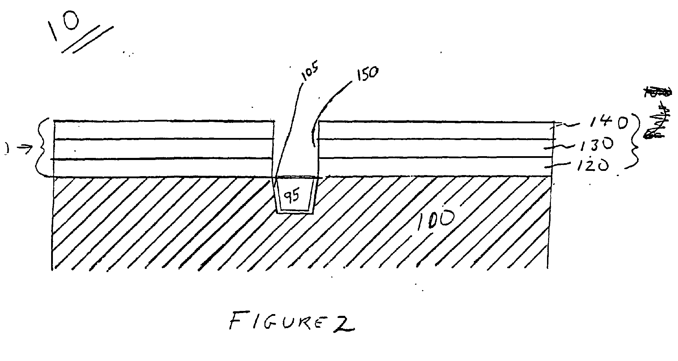

According to the invention, prior to passivation of the upper interconnect level 70, wire bonding may be effected by the following process sequence which provides an Al bond pad for electrical connection between the member 80 of interconnect level 70 and a package contact. See now Figures 2 through 4 which each provide a cross sectional view of the structure 10 taken along a plane orthogonal to the plane along which the view of Figure 1 is taken. Figure 2 illustrates the runner portion 95 of the Cu interconnect member 80 in level 70 of the circuit structure 10. A sub-layer 100 of interlevel dielectric is shown surrounding the runner portion 95 and a layer 105 of barrier material, e.g., TaN, is illustrated adjacent the runner portion 95.

With reference to Figure 2 a multilayer dielectric stack 110 is first formed over the surface of layer 100 covering the runner portion 95 of the member 80. The stack 110 comprises a deposited silicon nitride sublayer 120 formed over sublayer 100, a deposited silicon dioxide sublayer 130 formed over sublayer 120 and a second silicon nitride sublayer 140 formed over sublayer 130. The sublayer 140 has an exposed surface 145. The stack is patterned and etched to create a via 150 which exposes the runner portion 95. See again Figure 2. The stack materials may be deposited by CVD.

A layer 170 of barrier material is next deposited to line the via 150, followed by physical vapor deposition (PVD) of an Al contact layer 175 which fills the via. The deposited barrier layer can range from 10 to 50 nm in thickness although preferred thicknesses are from 20 to 30 nm. Possible materials for layer 170 include Ta, TaN, MoN and TiN, although other refractory metals and compounds thereof may also be suitable for inhibiting migration of Cu and Al. If Ta is chosen for the barrier layer 170, the Ta in contact with the Al will react to form TaAl3, this providing a conductive metallurgical bond. Underlying unreacted Ta provides the needed conductive barrier to inhibit metal migration.

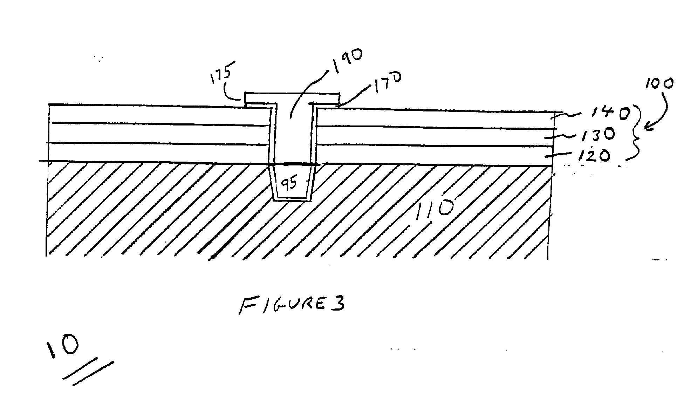

The structure is patterned and etched to define the bond pad by removal of both barrier material and Al from along the upper surface of silicon nitride sublayer 140. The patterning leaves portions of the barrier layer 170 and the Al layer 175 overlying the sublayer 140. The resulting Al bond pad 190 is illustrated in Figure 3. Alternately, barrier material of layer 170 and Al may be removed from the surface 145 of the silicon nitride layer 140 by CMP, leaving exposed surfaces of the bond pad 190 and the sublayer 140 coplanar.

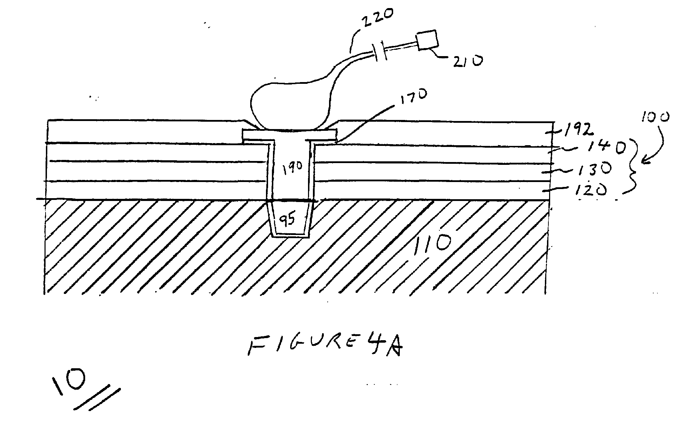

With the Al bond pad 190 in place a silicon nitride passivation layer 192 is deposited, patterned and etched to expose a surface 195 of the bond pad for metallurgical contact with a bond wire or solder bump in order to effect connection with an electrical contact external to the circuit structure 10. As shown in Figure 4A such a connection is made between the Cu runner 95 and a package contact 210 (only shown schematically) via a conventional Au wire 220. The Au wire is bonded to the Al pad 190. Thermocompressive, thermosonic and ultrasonic bonding techniques are applicable.

Figure 4B illustrates the structure of Figure 3 in an inverted position and adapted for face-down solder bump interconnection (referred to as flip chip or Controlled Collapse Chip Connection). Again a silicon nitride passivation layer has been deposited, patterned and etched to expose a surface 195 of the bond pad for metallurgical contact.

A stack layer 225 (e.g., Cu-Sn over CuCr over Cr) is deposited over the passivation layer 192, then patterned and etched. A solder ball 230 is deposited on the layer 225 for contact with a corresponding second solder ball 235. The second solder ball 235 is formed on the contact region 240 of a substrate 245.

While the partial view of Figure 4B includes only a small portion of the substrate 240 it is to be understood that the substrate comprises an array of solder balls 235. Each solder ball 235 is positioned on a contact region 245 for contact with a different and corresponding solder ball 230 formed on the structure 10 according to the invention. Although not illustrated, a thick film glass stop-off may surround the solder ball 225 to limit solder flow.

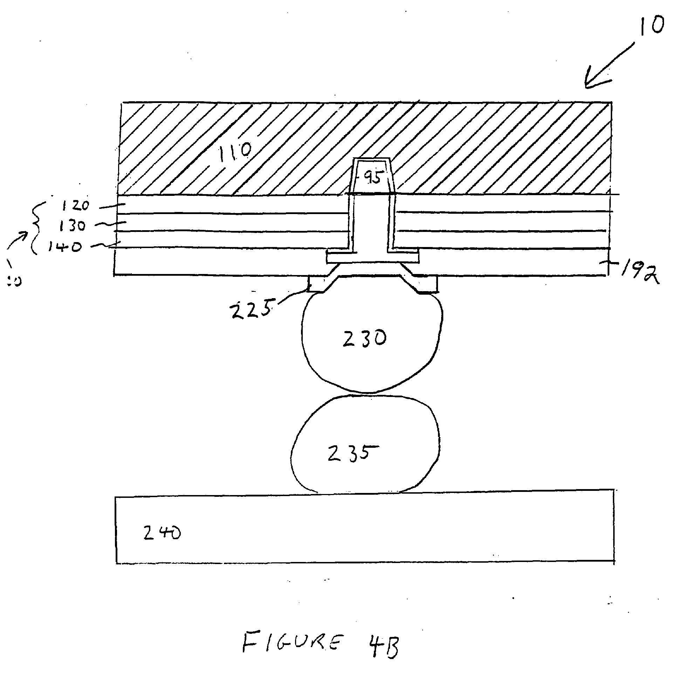

According to an alternate embodiment of the invention the bonding of a Au wire to an Al bond pad may be further integrated in a dual Damascene architecture. See Figures 5 through 8 which, based on the circuit structure 10 of Figure 1, illustrate formation of an Al bond pad to effect wire bonding with the runner level in a dual Damascene structure. Figures 5 through 8 again provide partial cross sectional views of the runner portion 95 of the Cu interconnect member 80 in level 70. The views of this embodiment are taken along a plane orthogonal to the plane along which the view of Figure 1 is taken. As described for the earlier embodiment of Figures 2 through 4, a sub-layer 100 of interlevel dielectric surrounds the runner portion 95 and a layer 105 of barrier material adjoins the runner portion 95.

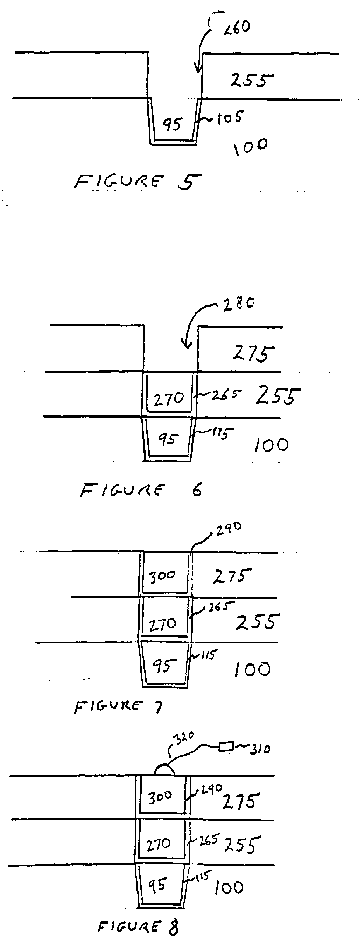

Referring first to Figure 5, formation of another dual Damascene structure is begun over the runner portion 95 of member 80. A dielectric layer 255 is deposited over the sub- layer 100, followed by creation of a first via opening 260. As shown in Figure 6 a layer 265 of barrier material (e.g., TaN) is formed in the opening 260 and the opening 260 is then filled with electroplated copper and polished as aforedescribed to provide a Cu contact portion 270. Next, another dielectric layer 275 is deposited and etched to form a second via opening 280 over the contact portion 270. See again Figure 6. Subsequently a layer 290 of conductive barrier material, e.g., TaN, is deposited to line the via opening 280, followed by deposition of an Al contact layer which fills the opening. As noted for the embodiment of Figure 3, the deposited barrier layer can range from 10 to 50 nm in thickness although preferred thicknesses are from 20 to 30 nm; and possible barrier materials for layer 270 include Ta, TaN, MoN and TiN, while other refractory metals and compounds thereof may again be suitable.

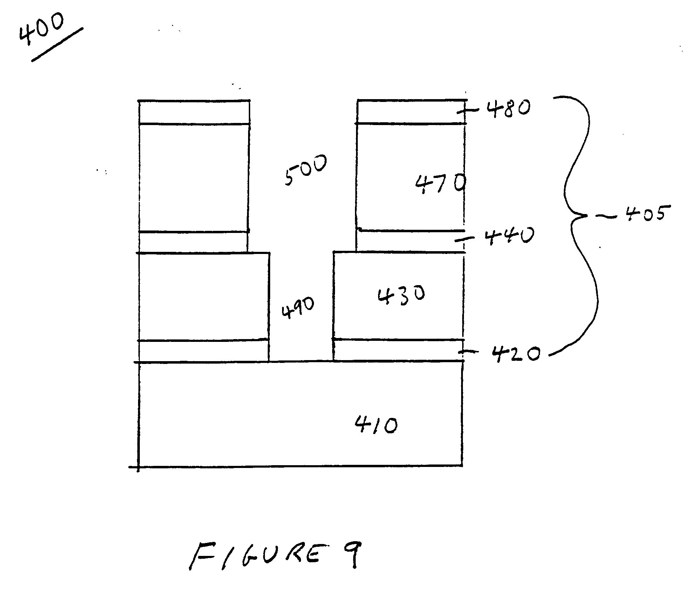

The exposed surfaces may then be polished (CMP) to remove portions of the Al contact layer and barrier material along the upper surface of the dielectric layer 275. Thus an Al bond pad 300 is formed in the opening 280. The resulting structure is shown in Figure 7. Next, referring to Figure 8, connection is made between the Cu contact portion 270 and a package contact 310 (only shown schematically) by thermocompressive bonding of a Au wire 320 to the Al pad 300. The wire 320 is also bonded to the contact 310.

A second alternate embodiment of the invention is illustrated in Figures 9 through 11. A circuit structure 400 includes an exemplary dual Damascene structure 405 formed over a Cu metalization level 410 with a silicon nitride barrier 420 formed thereon, a silicon dioxide layer 430 deposited over the barrier 420 and a second silicon nitride barrier 440 formed over the layer 430. Next another layer 470 of silicon dioxide is deposited over the barrier 440, followed by an optional deposition of a third silicon nitride barrier 480. These materials are exemplary only and are not essential to the invention.

Photoresist is deposited over the barrier 480 and patterned to etch a via 490 extending from the barrier 480, through the oxide layer 470, the barrier 440, and the oxide layer 430 to the barrier 420. The photoresist is removed and another level of photoresist is applied over the barrier 480 to pattern a trench region 500 which is etched from the barrier 480 and through the oxide layer 470. The trench region 500 is formed over the via 490 and is symmetrically aligned with the via 490. The portion of the nitride barrier 420 in the via 490 and the portion of the nitride barrier 480 within the defined trench region 500 are etched away. The resulting structure is shown in Figure 9. The foregoing steps are exemplary and the invention is not limited to this sequence.

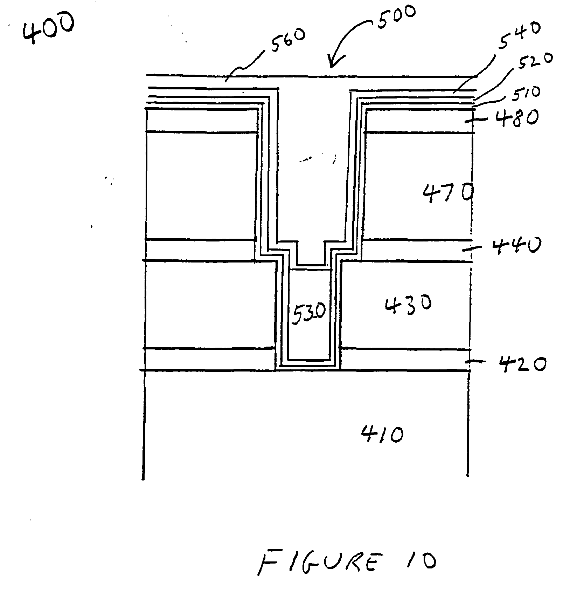

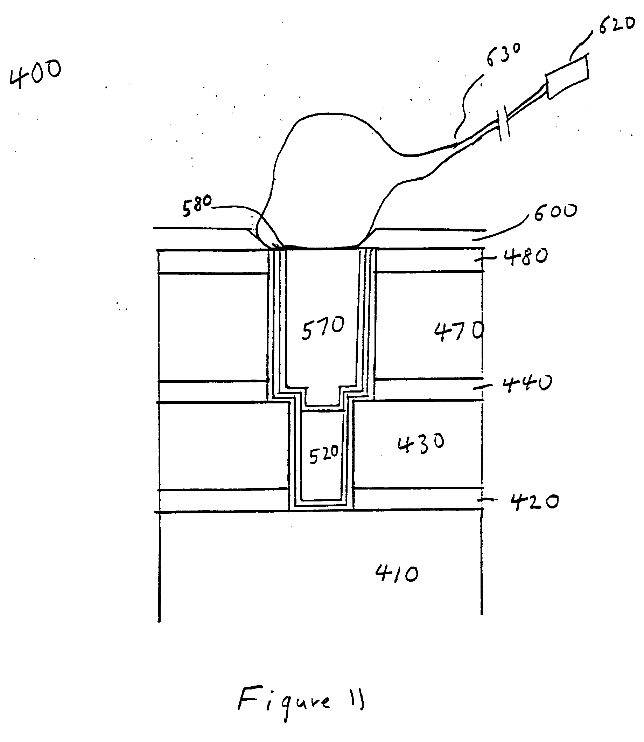

A layer 510 of conductive barrier material, e.g., Ta or TaN, is deposited to line the via 490 and the trench 500. A seed layer 520 of Cu is deposited in the via 490 and in the trench region 500 followed by electrodeposition of Cu to fill a portion or all of the via 490 forming a Cu contact 530. A second layer 540 of conductive barrier material, e.g., TaN, is deposited in the trench region 500 and over the Cu contact 530. A layer 560 of Al is deposited over the barrier metal and reflowed. See Figure 10. Subsequently, portions of the Al layer 560 and other metal layers about the trench region 500 are removed by CMP to define an aluminum bond pad 570 having an exposed surface 580. At this point the silicon nitride layer 480 is also exposed. Another silicon nitride layer 600 is deposited over the structure 400, patterned and etched to expose the surface 580 of the bond pad 570 for metallurgical contact with a wire bond or solder bump. See Figure 11 which further illustrates connection made from the Cu contact 530, through the Al bond pad 570 and to a package contact 620 (shown schematically) via a gold wire 630 bonded to the Al pad 570 by thermocompression. It is noted that while the illustrated bond pad 570 extends into the via 490 (Figure 9) this is not necessary. Rather, the Cu contact 530 and the layer 540 of barrier material may fill the entire via or even extend into the trench 500. Again, these materials are exemplary only and are not essential to the invention.

With regard to both the described embodiments and the claimed invention, multiple species of materials disclosed for practicing the invention at times have been described or claimed generally as one material, e.g., dielectric material such as silicon nitride or silicon dioxide; while various forms of each may be applied alone or in combination, e.g., in layers or discretely in separate portions of a circuit structure. It should be understood that any reference to applying these materials may contemplate application of various species of similar material in multiple layers. Thus several references to silicon dioxide should be understood to mean that various forms (perhaps differing in density or dielectric constant) may be implied so long as such use is consistent with semiconductor manufacture. Further, the term 'barrier material' as used herein and in the claims is meant to describe a material which is formed along a metal layer, e.g., Cu or Al, to mitigate migration of the metal into other portions of an integrated circuit structure. The barrier material may be conductive or insulative. As noted above, suitable conductive barrier materials include but are not limited Ta, TaN, TiN and MoN.

Although the invention has been described with regard to Damascene embodiments, these are only illustrative and the principles disclosed herein provide a basis for practicing the invention in a variety of ways on a variety of circuit structures. Although for the disclosed embodiments Cu is understood to be a primary constituent of the interconnect, other interconnect materials are contemplated, including Al and other elemental metals, alloys and conductive compounds, the choice depending on the specific electrical, thermal and other physical properties desired for the application. Although the disclosed embodiments illustrate a silicon structure, the invention may be practiced on semiconductor devices incorporating compound semiconductor materials including but not limited to materials such as Si-Ge, GaAs and InGaAs. Other constructions, although not expressly described herein, do not depart from the scope of the invention which is only limited by the claims which follow.

## Claims

1. An integrated circuit comprising:
a segment of conductor on an integrated circuit die having a contact region for electrical connection;
a bond pad; and
a conductive barrier layer disposed between the contact region and the bond pad for mitigating migration of conductor segment constituents from the contact region to the bond pad.

2. The circuit of claim 1 wherein the segment of conductor comprises Cu.

3. The circuit of claim 1 wherein the bond pad comprises Al.

4. An integrated circuit device comprising:
a first segment of conductor, formed on an integrated circuit die, predominantly comprising Cu and having a contact region for electrical connection with dissimilar material;
a conductive barrier layer formed about the contact region for preventing migration of Cu atoms from the contact region to other conductor material; and
an Al bond pad formed about the barrier layer such that the barrier layer is disposed between the contact region and the bond pad.

5. The integrated circuit device of claim 4 further including a bond wire, predominantly comprising Au, mechanically connected to the conductive layer for electrical connection thereto.

6. The integrated circuit device of claim 4 wherein the barrier layer comprises one or more materials selected from the group consisting of TaN, TiN and Ta.

7. The integrated circuit device of claim 4 wherein the barrier layer comprises a refractory metal.

8. The integrated circuit device of claim 4 wherein the barrier layer comprises a refractory metal compound.

9. The integrated circuit device of claim 4 wherein:
the first segment of conductor is formed in a Damascene structure comprising a first dielectric material having an upper surface and a trench region extending from within the dielectric material and through the upper surface; and
the contact region, the barrier layer and the bond pad are formed in the trench region.

10. The integrated circuit device of claim 4 wherein the first segment of conductor is one of a plurality of conductive members in a level of interconnect on an integrated circuit structure.

11. The integrated circuit device of claim 10 wherein the first segment is a runner portion of said one conductive member.

12. The integrated circuit device of claim 4 further including a solder bump interconnection for contact with a substrate.

13. A method for making an integrated circuit device comprising the steps of:
forming a first segment of conductor;
forming a bond pad for electrical connection with the first segment; and
forming a conductive barrier layer interposed between the first segment and the bond pad to mitigate migration of conductor material from the first segment to the bond pad.

14. The method of claim 22 further including:
providing an external contact; and
positioning a conductive layer between the bond pad and the external contact.

15. A method for making a integrated circuit device having interconnect formed on a die and an external contact separated from the die, comprising the steps of:
forming a first segment of conductor comprising Cu on the die in electrical contact with a portion of the interconnect;
forming a conductive barrier layer about at least a portion of the first segment to mitigate migration of Cu from the first segment;
forming a contact layer comprising Al in electrical connection with the barrier layer; and
positioning a conductive layer comprising Au for electrical connection between the contact layer and the external contact.

16. A method for making an integrated circuit device having a connection between copper-containing interconnect in an integrated circuit die and an external contact, comprising the steps of:
forming a conductive barrier layer in electrical contact with the interconnect;
forming a contact layer comprising Al in electrical connection with the barrier layer; and
positioning a conductive material for electrical connection between the contact layer and the external contact.

17. The method of claim 26 wherein the contact layer is a bond pad and the conductive material is a bond wire.

18. The method of claim 26 wherein the conductive material is formed from one or more solder balls.

19. The method of claim 26 wherein the conductive material predominantly comprises Au.

20. The method of claim 26 wherein the portion of the interconnect in contact with the conductive barrier predominantly comprises electroplated copper.

21. A method making an integrated circuit device having a connection between copper-containing interconnect in an integrated circuit structure and an external contact, comprising the steps of:
forming a dual Damascene structure in a dielectric stack comprising a first silicon nitride layer formed over the first upper level, a first silicon dioxide layer formed over the silicon nitride layer, a second silicon nitride layer formed over the first silicon dioxide layer and a second silicon dioxide layer formed over the second silicon nitride layer;
etching a first via from the second silicon dioxide layer to the first silicon nitride layer;
etching a trench region extending from the second silicon dioxide layer and toward the first silicon dioxide layer;
removing a portion of the first silicon nitride layer extending into the via to expose a portion of the first upper level;
removing a portion of the second silicon nitride layer to define a lower portion of the trench region along an upper surface of the second layer of silicon dioxide.
forming a layer of conductive barrier material over portions of the via and the trench region;
forming a conductive layer comprising Cu in the via;
forming a second layer of conductive barrier material over the conductive layer and portions of the trench region;
forming a layer of Al over the second layer of conductive barrier material; and
removing portions of the Al layer extending over the second layer of silicon dioxide to define an Al bond pad.

22. The method of claim 31 further including the step of connecting the Al bond pad to the external contact with a bond wire comprising Au.
